# EUROPEAN PATENT APPLICATION

(11) **EP 3 668 301 A1**
(43) Date of publication of application: **17.06.2020**
(21) Application number: 18211636.8
(22) Date of filing: 11.12.2018
(51) Int. Cl.: H05K 13/04

(54) **COMPONENT MOUNTING ARRANGEMENT AND RELATED METHODS**

(71) Applicant: Mycronic AB, 183 03 Täby (SE)
(72) Inventor: Walther, Jonas, 169 37 SOLNA (SE)
(74) Representative: AWA Sweden AB

(57) **Abstract**

The present inventive concept relates to a component mounting arrangement (100), comprising a picking tool (102) for picking and placing components, wherein the picking tool extends along a first axis (A), a carriage (104) for moving the picking tool back and forth along the first axis, and a locking arrangement comprising an electromagnetic coil (110). The locking arrangement is configured to selectively assume a first state, wherein the picking tool and the carriage are coupled by means of a magnetic force generated by the electromagnetic coil, wherein the magnetic force is sufficient to move the picking tool from a resting position, and a second state, wherein the picking tool and the carriage are uncoupled, thus allowing the picking tool to remain in the resting position when the carriage is moved.

## Description

### Technical field

The inventive concept described herein generally relates to component mounting arrangements and pick and place technology.

### Background

Machines for pick-and-place mounting of components on a workpiece, such as Printed Circuit Board (PCB), or a substrate for a System in Package (SiP), are subject to different, often contradictory demands, such as mounting speed, mounting precision, size, price, etc. The expression "pick and place" may be understood by the person skilled in the art as describing the very mounting operation where a mounting head is moved to a component feeder area, where the mounting head picks one or more components from one or more of the component feeders, and then is moved to a mounting area where the mounting head places the component or components on the workpiece.

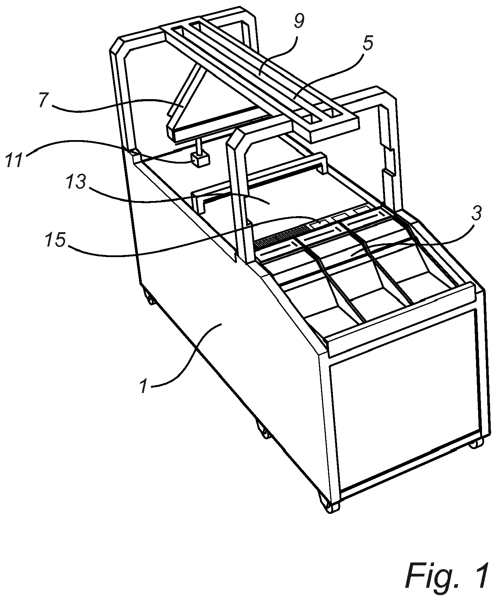

A schematic example of a component mounting machine is shown in FIG. 1 of the attached drawings. It comprises a machine frame 1, a component feeding device 3, including a plurality of component feeders, arranged at a component feeder area of the machine frame 1, a gantry system 5 having a first beam, or X beam 7, and a second perpendicular beam, or Y beam 9, attached to the machine frame 1, a component mounting arrangement 11 movably attached to the X beam 7, and a board transportation system 13, attached to the machine frame 1. The component feeding device 3 presents electronic components to the component mounting arrangement 11. The board transportation system 13 transports substrates between a conveyor line and a working area of the component mounting machine. The component mounting arrangement 11 is movable along the X beam 7 and the X beam is movable along the Y beam 9. Thereby, the gantry system 5 makes it possible to move the component mounting arrangement 11 between the component feeding device 3 and the substrate. Further, the component mounting arrangement 11 is movable in the vertical direction, and is also able to rotate around a vertical axis. It also contains a suction device. This makes it possible to pick up, by activating the suction device, electronic components from the component feeding device 3, transport them to the substrate, and place them at a precise location on the substrate. During the transport from pick up to the substrate a vision centering device 15 is passed to get an accurate position of picked components. There also exists similar component mounting machines having a fixed gantry system.

A picking tool of the component mounting arrangement should preferably be able to withstand a significant amount of repeated movement between a picking/placing position and an idle position. Further, the mounting head of a picking tool may have to be changed several times to be able to pick a specific type of component, which may differ in size, shape, and weight.

There is a need for improved component mounting arrangements.

### Summary of the invention

To better address one or more of these concerns, a component mounting arrangement, a component mounting machines comprising such arrangement, and a method having the features defined in the independent claims are provided. Preferable embodiments are defined in the dependent claims.

According to a first aspect of the inventive concept, a component mounting arrangement is provided, comprising: a picking tool for picking and placing components, wherein the picking tool extends along a first axis; a carriage for moving the picking tool back and forth along the first axis; a locking arrangement comprising an electromagnetic coil, wherein the locking arrangement is configured to selectively assume: a first state, wherein the picking tool and the carriage are coupled by means of a magnetic force generated by the electromagnetic coil, wherein the magnetic force is sufficient to move the picking tool from a resting position, and a second state, wherein the picking tool and the carriage are uncoupled, thus allowing the picking tool to remain in the resting position when the carriage is moved.

Hereby, a contactless coupling of the picking tool and the carriage may be achieved. An advantage with such an arrangement is that friction between the picking tool and the carriage, at least as generated by physical interaction between the picking tool and the carriage, may be decreased or even eliminated.

The coupling between the picking tool and the carriage may be achieved by arranging the electromagnetic coil such that it acts directly on the material of the picking tool, which hence may be a ferromagnetic material or a material forming a permanent magnet. Alternatively, or additionally, the locking arrangement may further comprise a ferromagnetic element and/or a permanent magnet element arranged to cooperate with the electromagnetic coil. The ferromagnetic element may hence be understood as an element comprising a ferromagnetic material, such as e.g. cobalt or iron, capable of being magnetically attracted by the electromagnetic coil.

Throughout the present disclosure, the term 'magnetic force' may be interchangeably used with the term 'coupling force' in the context of coupling the picking tool and the carriage.

The picking tool may be movable between a resting position and a placing and/or picking position. The placing and/or picking position may be a position where the picking tool may place a component on a surface, or a position where the picking tool may pick a component from a surface.

In one embodiment, the electromagnetic coil may be attached to the carriage. In addition, a ferromagnetic element and/or the permanent magnet element may be arranged on the picking tool, or form part of the picking tool. In particular, the picking tool may be divided into a plurality of sections along the first axis, wherein one of said plurality of sections comprises the ferromagnetic element and/or the permanent magnet element. The ferromagnetic element may be configured to be affected by an electromagnetic field generated by the electromagnetic coil. Similarly, the permanent magnet may be configured to be affected by an electromagnetic field generated by the electromagnetic coil. Hereby, movement of the carriage along the first axis may urge the picking tool in the same direction when the locking arrangement is in the first state, i.e. when the picking tool and the carriage are coupled by means of the magnetic force.

In one embodiment, it is envisioned that the electromagnetic coil is attached to the picking tool. Hereby, movement of the carriage along the first axis may urge the picking tool in the same direction when the locking arrangement is in the first state, i.e. when the picking tool and the carriage are coupled by means of the magnetic force. Further, the locking arrangement may comprise a ferromagnetic element and/or a permanent magnet element being arranged on the carriage. The ferromagnetic element may be configured to be affected by an electromagnetic field generated by the electromagnetic coil. Similarly, the permanent magnet may be configured to be affected by an electromagnetic field generated by the electromagnetic coil. Hereby, movement of the carriage along the first axis may urge the picking tool in the same direction when the locking arrangement is in the first state, i.e. when the picking tool and the carriage are coupled by means of the magnetic force.

The electromagnetic coil may generate the magnetic force by means of a current passed through the electromagnetic coil. The current may be provided by a current generator. It is to be understood that even in the second state of the locking arrangement, a current may be passed through the electromagnetic coil. However, the current in the second state may be below a threshold needed to generate a sufficient magnetic force to move the picking tool from a resting position.

The ferromagnetic element and/or the permanent magnet element may form a sleeve arranged on the picking tool.

The carriage may comprise a through-hole configured and arranged to allow the picking tool to extend through the through-hole. An inner diameter of the through-hole is preferably larger than an outer diameter of a lower section of the picking tool. The lower section of the picking tool may be defined as a section proximal to an intended picking and/or placing surface with respect to the ferromagnetic element and/or the permanent magnet element and an intended picking and/or placing surface. Hereby, at least the lower section of the picking tool may be able to extend through the through-hole and move with respect to the carriage. It is further envisioned that the through-hole may have an inner diameter being larger than an outer diameter of the picking tool. Hereby, the picking tool may be able to extend through the through-hole and move with respect to the carriage.

The electromagnetic coil may be wound about the first axis, and the picking tool may be arranged such that it extends through said electromagnetic coil. In particular, the electromagnetic coil may comprise a core having an inner diameter being larger than an outer diameter of the picking tool. Furthermore, the inner diameter of the electromagnetic coil may be larger than an outer diameter of the ferromagnetic element and/or the permanent magnet element arranged on the picking tool. Hereby, the ferromagnetic element and/or the permanent magnet element may move in said core with respect to the electromagnetic coil. The electromagnetic coil may comprise or be formed of copper.

Throughout the present disclosure, references are made to a 'core' of an electromagnetic coil. Such a core may be defined as the space in the center of the electromagnetic coil not occupied by the turns of the electromagnetic coil itself.

The electromagnetic coil may be wound about the first axis and arranged beside the picking tool. Hereby, a coupling between the picking tool and the carriage may be achieved without having the picking tool extending through the electromagnetic coil. It is further envisioned that the locking arrangement may comprise at least two electromagnetic coils arranged beside the picking tool. In particular, the at least two electromagnetic coils may be arranged symmetrically about the picking tool.

The electromagnetic coil may be wound about a second axis (B) being perpendicular to the first axis, and wherein said electromagnetic coil is arranged beside the picking tool. Hereby, a coupling between the picking tool and the carriage may be achieved.

The component mounting arrangement may be further configured to, in the first state, selectively adjust a current of the electromagnetic coil such that the magnetic force of the magnetic coupling between the picking tool and the carriage can be adjusted. Hereby, it may be possible to control a force with which the picking tool is placing components. For example, the carriage may be moved along the first axis towards a surface by e.g. a motor such as a servo motor exerting a first force on the carriage. Further, the electromagnetic coil may be selectively adjusted to achieve a magnetic coupling between the ferromagnetic element and/or the permanent magnet element and the electromagnetic coil, wherein the magnetic force of the magnetic coupling is equal to or less than the first force. In case the magnetic force is less than the first force, the magnetic coupling may "slip", i.e. the movement of the carriage towards the surface will not be transferred via the magnetic coupling to the picking tool, once the force of the carriage moving towards the surface exceeds the magnetic force, and thus the picking tool may only exert a placing force equal to the magnetic force. The current of the electromagnetic coil may be adjusted and/or controlled by a processing unit.

The component mounting arrangement may further comprise a docking arrangement configured to hold the picking tool in the resting position, wherein the docking arrangement comprises a first docking element arranged on a support body, and a second docking element arranged on the picking tool. The docking arrangement may be further configured to generate a docking force between the picking tool and the support body. In particular, a docking force may be generated between the first docking element and the second docking element.

The first docking element may comprise a permanent magnet docking element, and the second docking element comprises a ferromagnetic docking element. It is further envisioned that in an alternative embodiment, the first docking element may comprise the ferromagnetic docking element, and the second docking element may comprise the permanent magnet docking element. However, for the sake of brevity, the following disclosure only discuss the arrangement of the first docking element comprising the permanent magnet docking element, and the second docking element comprising the ferromagnetic docking element. The features and advantages apply however, *mutatis mutandis,* to the alternative embodiment.

The permanent magnet docking element and the ferromagnetic docking element may generate the docking force between the picking tool and the support body. Preferably, the docking force may be greater than a force of gravity exerted on the picking tool, thus providing for a docking arrangement capable of holding the picking tool in the resting position in configurations wherein the first axis is oriented along a vertical direction. Furthermore, the magnetic force of the magnetic coupling and/or the docking force is preferably adjusted such that the magnetic force is greater than the docking force when the locking arrangement is in the first state. Hereby, the carriage may be capable of overcoming the docking force when the locking arrangement is in the first state, and thus also be capable of moving the picking tool from its resting position.

Regarding the docking force, it may be noted that in case the docking force is a magnetic force, the docking force may be inversely proportional to a distance between the first docking element and the second docking element. The picking tool and support body, and in particular the first docking element and/or the second docking element, are preferably arranged such that an adequate docking force may be achieved by moving the picking tool towards the second docking element, via movement of the carriage along the first axis while having the locking arrangement in the first state.

The support body may comprise a through-hole along the first axis, wherein the picking tool is movable through said through-hole. The through-hole will hereinafter be referred to as a docking hole. The docking hole may allow part of the picking tool to be housed within the docking hole when the picking tool is in the resting position. The docking hole may also provide for that the picking tool may extend through the support body, and thus also through the docking hole. Hereby, a more secure docking of the picking tool may be achieved.

The first docking element may be ring shaped and arranged on an inner surface of the through hole, and the second docking element may form part of the picking tool. In particular, the second docking element may be sleeve shaped and arranged along the first axis on the picking tool. Furthermore, the picking tool may be divided into a plurality of sections along the first axis, wherein one of said plurality of sections comprises the second docking element.

The first docking element may have an inner diameter being larger than an outer diameter of the second docking element, thus allowing the picking tool to move along the first axis through said through-hole.

The docking arrangement may comprise at least two second docking elements arranged at different locations along the first axis on the picking tool, thus allowing the docking arrangement to hold the picking tool in at least two different resting positions along the first axis. In particular, the docking hole in the support body may allow the picking tool to be moved along the first axis without being restricted by the support body. Hereby, the picking tool may be moved along the first axis until a desired second docking element of the picking tool is located at the first docking element. A docking force may be generated between the first and second docking elements, e.g. a magnetic force may be generated, and the picking tool may then be left in the desired resting position. The locking arrangement may assume the second state in order to leave the picking tool at the desired resting position. Docking and movement of the picking tool will be further discussed in the detailed description of the present inventive concept.

The locking arrangement may comprise a latch configured to engage the picking tool in order to restrict movement of the picking tool towards the resting position. The latch may be configured to be operated via operation of the electromagnetic coil. The latch may engage with a surface of the picking tool being substantially perpendicular to the first axis. Furthermore, the latch may be securely attached to the carriage. Hereby, movement of the picking tool towards the resting position may be restricted. This may be useful when a mounting head for picking components is installed on the picking tool. Such mounting heads may be installed by pushing the mounting head on to a distal end of the picking tool. The distal end may be defined as an end closest to a surface for picking and placing components, whereas a proximal end may be defined as an opposite end of the picking tool. The upwardly directed force exerted on the picking tool when installing a mounting head may then be counteracted by the latch being in an engaged position. Hereby, it may be possible to install a mounting head on the picking tool without substantial movement of the picking tool relative the carriage and/or the support body.

The component mounting arrangement may further comprise a processing unit configured to monitor a property of the electromagnetic coil in order to determine when the component held by the picking tool makes contact with a surface. The property of the electromagnetic coil may comprise inductance of the electromagnetic coil. For example, the processing unit may be configured to monitor a current and a voltage of the electromagnetic coil, and may be further configured to calculate from the relationship between the monitored current and voltage an inductance of the electromagnetic coil. In a further example, the processing unit is configured to monitor the current and/or the voltage passed through the electromagnetic coil.

In yet a further example, a reference current may be overlaid in the electromagnetic coil, wherein the reference current is not for generating the coupling force. The amplitude of the reference current may be affected by the inductance of the electromagnetic coil. Hence, the processing unit may be configured to monitor the reference current in order to determine when the component held by the picking tool makes contact with a surface.

According to a second aspect of the inventive concept, a component mounting machine is provided, comprising the component mounting arrangement according to anyone of the above embodiments.

According to a third aspect of the inventive concept, a method for operating a component mounting arrangement is provided, comprising: a picking tool for picking and placing components, wherein the picking tool extends along a first axis; a carriage for moving the picking tool back and forth along the first axis; a locking arrangement comprising an electromagnetic coil, wherein the locking arrangement is configured to selectively assume: a first state, wherein the picking tool and the carriage are coupled by means of a magnetic force generated by the electromagnetic coil, wherein the magnetic force is sufficient to move the picking tool from a resting position, and a second state, wherein the picking tool and the carriage are uncoupled, thus allowing the picking tool to remain in the resting position when the carriage is moved; wherein the method comprises: passing an electrical current through the electromagnetic coil, thus generating the magnetic force and causing the locking arrangement to switch from the second state to the first state; and moving the carriage along the first axis, thus moving the picking tool along the first axis.

It is appreciated that the method according to the third aspect may be combined with the component mounting arrangement and machine described in connection with the first and second aspects.

The method may further comprise passing a first level of current through electromagnetic coil, thus generating the magnetic force and causing the locking arrangement to switch from the second state to the first state.

The method may further comprise selectively reducing the current passed through the electromagnetic coil to a second level as the picking tool approaches a picking and/or placing position. In other words, the method may further comprise selectively reducing the current passed through the electromagnetic coil to a second level when the picking tool passes a first point between the resting position and a picking and/or placing position. Hereby, the magnetic force may be reduced.

The method may further comprise selectively adjusting a current passed through the electromagnetic coil such that a strength of the magnetic coupling between the picking tool and the carriage can be adjusted.

The method may further comprise monitoring a property of the electromagnetic coil, via a processing unit, in order to determine when the component held by the picking tool makes contact with a surface.

Other objectives, features and advantages of the present inventive concept will appear from the following detailed disclosure, from the attached claims as well as from the drawings.

### Brief description of the drawings

The above, as well as additional objects, features and advantages of the present inventive concept, will be better understood through the following illustrative and non-limiting detailed description of different embodiments of the present inventive concept, with reference to the appended drawings, wherein:
FIG. 1 illustrates a schematic example of a component mounting machine;
FIG. 2 illustrates a component mounting arrangement in a perspective view;
FIG. 3 illustrates a locking arrangements in a perspective view;
FIG. 4 illustrates a docking arrangement in a perspective view;
FIG. 5 illustrates a docking arrangement in a perspective view;
FIG. 6a - 6b illustrate movement of a picking tool via a locking arrangement and a carriage;
FIG. 7 illustrates an embodiment of a locking arrangement in a perspective view;
FIG. 8 illustrates a latch; and
FIG. 9 illustrates a method for operating a component mounting arrangement in a flow chart diagram.

The figures are not necessarily to scale, and generally only show parts that are necessary in order to elucidate the inventive concept, wherein other parts may be omitted or merely suggested.

### Detailed description

FIG. 1 is a general illustration of a component mounting machine comprising a machine frame 1, a component feeding device 3, a gantry system 5 having a first beam, a component mounting arrangement 11 movably attached to the gantry system 5, and a board transportation system 13, attached to the machine frame 1. The gantry system 5 makes it possible to move the component mounting arrangement 11 between the component feeding device 3 and the substrate, at which the component can be released at a dedicated location.

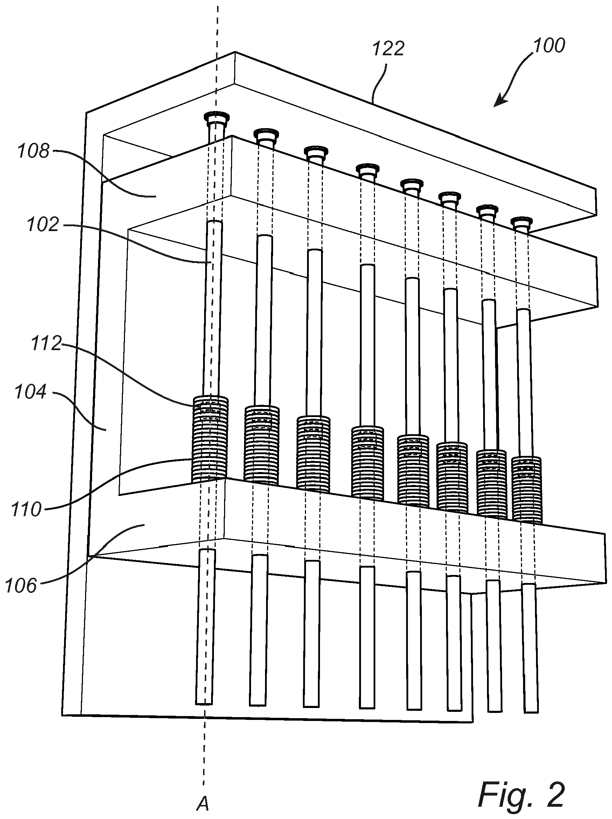

FIG. 2 illustrates a component mounting arrangement 100 according to an embodiment, comprising a picking tool 102 for picking and placing components. The picking tool extends along a first axis A. In the particular embodiment, the component mounting arrangement 100 comprises a plurality of picking tools 102. However, for the sake of brevity, the following disclosure will be made with reference to one picking tool.

The component mounting arrangement 100 may further comprise a carriage 104 for moving the picking tool 102 back and forth along the first axis A. The carriage 104 here comprises a bottom part 106 and a top part 108.

The component mounting arrangement 100 may further comprise a locking arrangement comprising an electromagnetic coil 110, wherein the locking arrangement is configured to selectively assume: a first state, wherein the picking tool 102 and the carriage 104 are coupled by means of a magnetic force generated by the electromagnetic coil 110, wherein the magnetic force is sufficient to move the picking tool 102 from a resting position, and a second state, wherein the picking tool 102 and the carriage 104 are uncoupled, thus allowing the picking tool 102 to remain in the resting position when the carriage 104 is moved.

The electromagnetic coil 110 is here attached to the carriage 104. In particular, the electromagnetic coil 110 is attached to the bottom part 106 of the carriage 104. It is however envisioned that the electromagnetic coil 100 may be attached to the top part 108 of the carriage 104. Further, at least one of the bottom part 106 or top part 108 not being attached to the electromagnetic coil 110 may be omitted. In particular, one advantage of the present inventive concept is that a length of the picking tool 102 along the first axis A may be decreased compared to conventional component mounting arrangements. Accordingly, a top part 108 of the carriage 104, functioning at least partly as a guide for the picking tool 102, may not be needed.

The electromagnetic coil 110 is here wound about the first axis A, and the picking tool 102 is arranged such that it extends through the electromagnetic coil 110.

The locking arrangement here comprises a permanent magnet element 112 forming part of the picking tool 102. The permanent magnet element 112 and/or the electromagnetic coil 100 are preferably arranged and configured such that when the carriage 104 is at an end position, the permanent magnet element 112 is arranged within the electromagnetic coil 110. Hereby, when a current is passed through the electromagnetic coil 110, a magnetic field may be generated which in turn generates a magnetic force between the permanent magnet element 112 and the electromagnetic coil 110, thus coupling the picking tool 102 and the carriage 104.

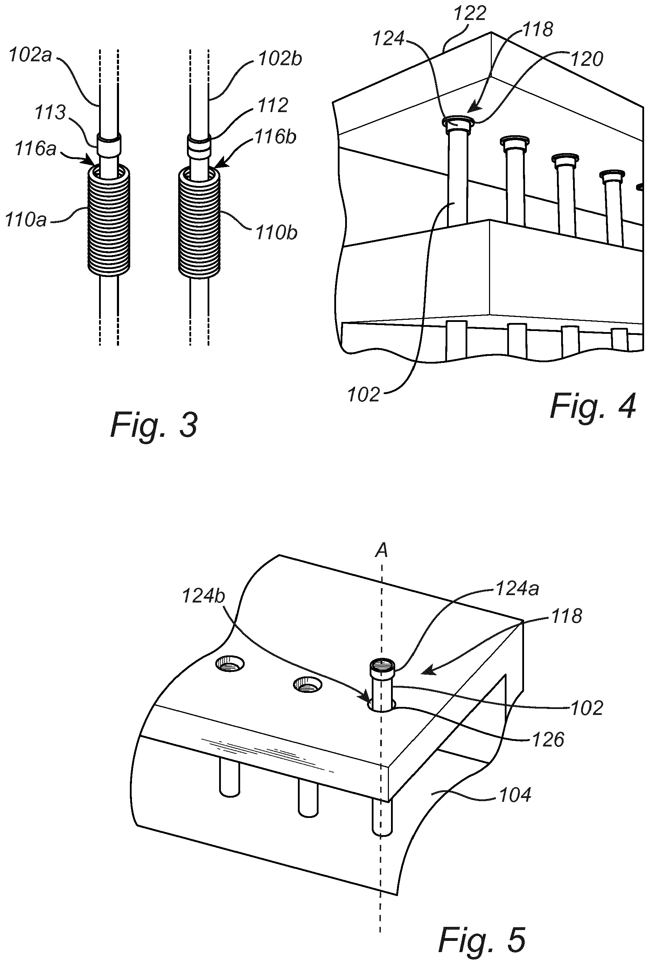

FIG. 3 illustrates a close up of embodiments of the locking arrangement. The leftmost part of the figure illustrates a locking arrangement comprising a ferromagnetic element 113 forming a sleeve on the picking tool 102a. The ferromagnetic element 113 has an outer diameter being smaller than an inner diameter of the electromagnetic coil 110a. Further, the inner diameter of the electromagnetic coil 110a defines a core 116a. Hereby, the ferromagnetic element 113 may move in and/or through said core 116a with respect to the electromagnetic coil 110a.

The rightmost part of FIG. 3 illustrates a locking arrangement comprising a permanent magnet element 112 forming a sleeve on the picking tool 102b. The permanent magnet element 112 has an outer diameter being smaller than an inner diameter of the electromagnetic coil 110b. Further, the inner diameter of the electromagnetic coil 110b defines a core 116b. Hereby, the permanent magnet element 112 may move in and/or through said core 116b with respect to the electromagnetic coil 110b.

FIG. 4 illustrates a docking arrangement 118 configured to hold the picking tool 102 in the resting position. The docking arrangement 118 comprises a first docking element 120 arranged on a support body 122, and a second docking element 124 arranged on the picking tool 102. The first docking element 120 here comprise a permanent magnet docking element, and the second docking element 124 comprises a ferromagnetic docking element. In the illustrated figure, the picking tool 102 is in the resting position. In the resting position, a docking force (e.g. a magnetic force) may be generated as a result of the mutual attraction of the first docking element 120 and the second docking element 124. The docking force causes the picking tool 102 to remain in the resting position.

FIG. 5 illustrates a docking arrangement 118 wherein a plurality of second docking elements are arranged on the picking tool 102. The second docking elements are here ferromagnetic docking elements. A first ferromagnetic docking element 124a is arranged at a first location of the picking tool 102 along the axis A. A second ferromagnetic docking element 124b (obstructed by the support body 122 and therefore not visible in this view) is displaced with respect to the first ferromagnetic docking element 124a along the axis A and arranged on the picking tool 102.

The picking tool 102 has here been moved along the first axis A by the carriage 104, and the picking tool 102 extends a docking hole 126 in the support body 122. The second ferromagnetic docking element 124b is here interacting with a first docking element (not shown), e.g. a permanent magnet element, arranged on the support body 122, similarly to what was disclosed in conjunction with FIG. 4, and a docking force is generated. The picking tool 102 here thus assumes a second resting position, wherein the picking tool 102 is lifted further away from a surface where components are picked and/or placed. It is envisioned that several ferromagnetic docking elements may be arranged on the picking tool 102 along the first axis A in order to provide for further resting positions. It is further to be understood that although the above disclosure is made with reference to a first docking element being a permanent magnet element and the second docking element being a ferromagnetic docking element, the above advantages and effects may also be achieved by a first docking element being a ferromagnetic docking element and the second docking element being a permanent magnet element.

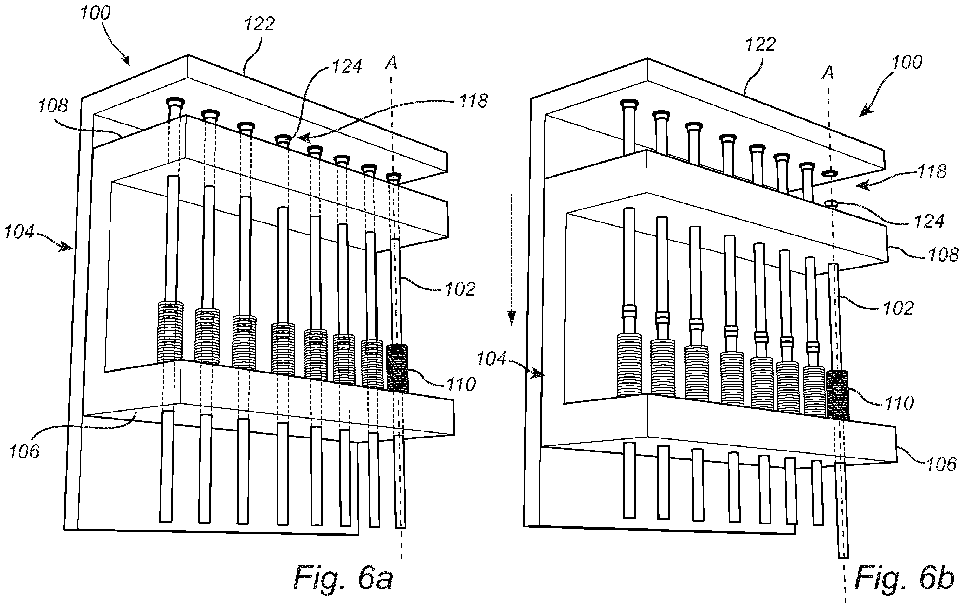

FIG. 6a - 6b illustrate movement of a picking tool via a locking arrangement and a carriage according to an embodiment that may be similarly configured as the embodiments described in connection with the previous figures. It may be noted that it is envisioned that any number of picking tools may be selectively moved between their respective resting position and a placing and/or picking position by selectively activating the respective locking arrangement, e.g. the electromagnetic coil arranged and associated with the picking tool.

FIG. 6a illustrates the component mounting arrangement 100 in a state wherein the picking tool 102 is arranged in its resting position, in which it is attached to the support body 122 by means of the docking arrangement, and wherein the locking arrangement is arranged in the uncoupled, second state. In this state, the carriage 104 is allowed to move back and forth along the first axis A while the picking tools 102 (in the present example the component mounting arrangement 100 comprises eight picking tools) are maintained in the resting position.

FIG. 6b illustrates the component mounting arrangement 100 in a state wherein one of the picking tools 102 has been moved along with the movement of the carriage 104 towards a picking position or a workpiece (not shown). In the present example, the carriage 104 has been moved downwards along the first axis A, in a direction indicated by the arrow in FIG. 6b, and coupled to the picking tool 102 by means of a magnetic attraction between the electromagnetic coil 110 and the picking tool 102. The coupling is achieved by arranging the locking arrangement in the first state, in which the electromagnetic coil 110 is activated to generate a magnetic interaction with a permanent magnet element 112 arranged on the picking tool 102. The electromagnetic coil 110 is in this example attached to the bottom part 106 of the carriage 104, thereby allowing the picking tool 102 to follow the motion of the carriage. The coupling force between the carriage 104 and the picking tool 102 is configured to be strong enough to exceed the docking force between the support body 122 and the ferromagnetic docking element 124 of the picking tool 102. By employing an electromagnetic coil 110, the coupling force may be varied depending on the desired performance. The coupling force may for example be increased in case the carriage 104 is operated at higher acceleration rates so as to ensure that the picking tool 102 follows the acceleration. Further, the coupling force may be reduced so as to not induce mechanical damage to sensitive components during mounting. It is also appreciated that the coupling force may be varied dynamically as the picking tool 102 is moved. The coupling force may for example be increase during initial, downward movement of the carriage 104, and reduced close to the picking position and/or the workpiece.

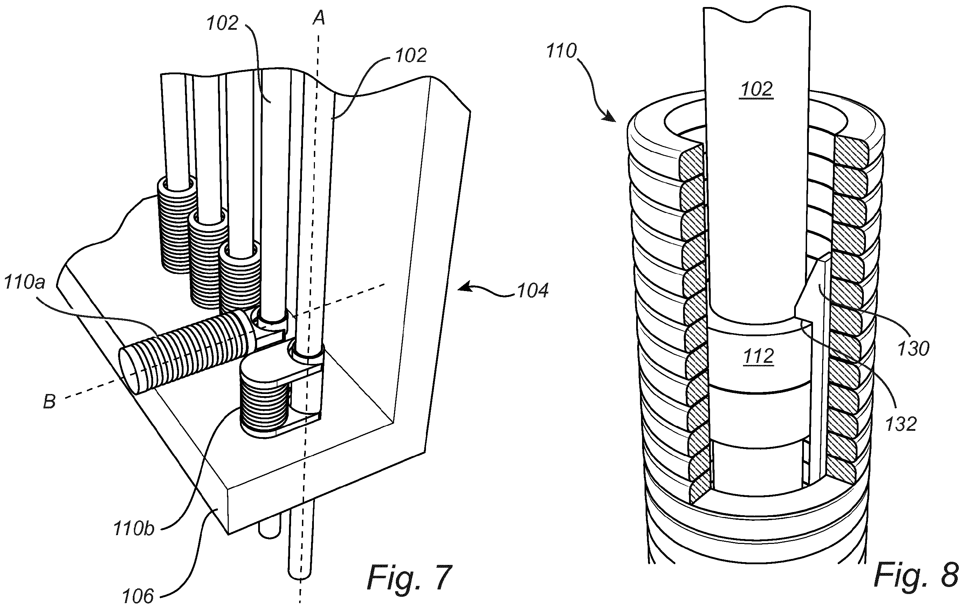

FIG. 7 illustrates an embodiment of a locking arrangement according to an embodiment, which may be similarly configured as the embodiments described with reference to the previous figures. In this example, the locking arrangement may comprise an electromagnetic coil 110a that is wound about a second axis B, which may be perpendicular to the first axis A. This allows for the coil 110a to act on the picking tool 102 from the side. In an embodiment having several picking tools arranged side by side, the arrangement of the electromagnetic coils as described above may be advantageous in that a size of the electromagnetic coils, such as the diameter and/or the height of the electromagnetic coils, may be increased. By increasing the size of the electromagnetic coils, the coupling force may be increased. A further advantage with such an arrangement is that several picking tools may be arranged closer together, i.e. spaced apart with a shorter spacing between the respective picking tools, along at least one direction being perpendicular to the first axis A, as compared to an arrangement wherein the picking tool extends through the coil.

In a further example, the locking arrangement may comprise an electromagnetic coil 110b that is wound about an axis parallel to the first axis A, but arranged beside the picking tool 102. Thus, the coupling between the picking tool 102 and the carriage 104 may be achieved without having the picking tool 102 extending through the core of the electromagnetic coil 110b. Similarly to the above, in an embodiment having several picking tools arranged side by side, the arrangement of the electromagnetic coils as described above may be advantageous in that a size of the electromagnetic coils, such as the diameter and/or the height of the electromagnetic coils, may be increased. By increasing the size of the electromagnetic coils, the coupling force may be increased. Further, several electromagnetic coils may be arranged in a staggered configuration along the picking tools, thus providing more space for each electromagnetic coil. Also similarly to the above, a further advantage with such an arrangement is that several picking tools may be arranged closer together, i.e. spaced apart with a shorter spacing between the respective picking tools, along at least one direction being perpendicular to the first axis A, as compared to an arrangement wherein the picking tool extends through the coil.

FIG. 8 illustrates a locking arrangement that further comprises a latch mechanism 130 configured to engage the picking tool 102 in order to restrict movement of the picking tool 102 towards the resting position. The latch mechanism 130 may be arranged within the electromagnetic coil 110 and comprise a shoulder 132 for engaging a corresponding structure of the picking tool 102. In the present example, the shoulder 132 may be arranged to engage a vertical surface, normal to the first axis A, of the permanent magnet element 112 arranged on the picking tool 102.

The latch mechanism 130 may be spring biased and moveable in a direction allowing it to assume a locking state, in which it engages the picking tool 102, and a released state in which it allows the picking tool 102 to move freely relative the latch mechanism 130. The spring biasing may be configured to push the latch mechanism 130 into the released state, and to be counteracted by a magnetic force generated by the electromagnetic coil 110 when the locking arrangement assumes its first, coupling state. In other words, the latch mechanism 130 may be activated, i.e., brought into its locking state, by the magnetic field generated as the electromagnetic coil 104 couples the picking tool 102 to the carriage 104.

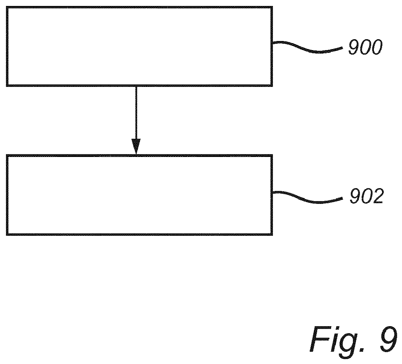

A method for operating a component mounting arrangement according to the inventive concept will now be described with reference to an example embodiment disclosed in FIG. 9.

The component mounting arrangement may comprise a picking tool for picking and placing components, a carriage for moving the picking tool back and forth along a first axis, and a locking arrangement comprising an electromagnetic coil as described in connection with the previously discussed embodiments. The method may comprise a step of passing 900 an electrical current through the electromagnetic coil to generate a magnetic force and to cause the locking arrangement to switch from its second state, in the picking tool and the carriage are uncoupled and the picking tool remains in the resting position, to the first state in which the picking tools and the carriage are coupled by means of a magnetic force generated by the electromagnetic coil. The method may further comprise a step of moving 902 the carriage along the first axis, thus moving the picking tool along the first axis from the resting position towards a picking position or a surface of a workpiece.

The inventive concept has mainly been described above with reference to a few embodiments. However, as is readily appreciated by a person skilled in the art, other embodiments than the ones disclosed above are equally possible within the scope of the inventive concept, as defined by the appended patent claims.

## Claims

1. A component mounting arrangement (100) comprising:
a picking tool (102) for picking and placing components, wherein the picking tool extends along a first axis (A);
a carriage (104) for moving the picking tool back and forth along the first axis;
a locking arrangement comprising an electromagnetic coil (110), wherein the locking arrangement is configured to selectively assume:
a first state, wherein the picking tool and the carriage are coupled by means of a magnetic force generated by the electromagnetic coil, wherein the magnetic force is sufficient to move the picking tool from a resting position, and
a second state, wherein the picking tool and the carriage are uncoupled, thus allowing the picking tool to remain in the resting position when the carriage is moved.

2. The component mounting arrangement according to claim 1, wherein the electromagnetic coil is attached to the carriage.

3. The component mounting arrangement according to claim 1 or 2, wherein the locking arrangement comprises a ferromagnetic element (113) and/or a permanent magnet element (112) forming part of the picking tool.

4. The component mounting arrangement according to claim 3, wherein the ferromagnetic element and/or the permanent magnet element forms a sleeve arranged on the picking tool.

5. The component mounting arrangement according to any one of claims 1 to 4, wherein the electromagnetic coil is wound about the first axis, and wherein the picking tool is arranged such that it extends through said electromagnetic coil.

6. The component mounting arrangement according to any one of the preceding claims, further configured to, in the first state, selectively adjust a current of the electromagnetic coil such that a strength of the magnetic coupling between the picking tool and the carriage can be adjusted.

7. The component mounting arrangement according to any one of the preceding claims, further comprising a docking arrangement (118) configured to hold the picking tool in the resting position, wherein the docking arrangement comprises a first docking element (120) arranged on a support body (122), and a second docking element (124) arranged on the picking tool.

8. The component mounting arrangement according to claim 7, wherein the first docking element comprises a permanent magnet docking element, and the second docking element comprises a ferromagnetic docking element.

9. The component mounting arrangement according to claim 7 or 8, wherein the support body comprises a through-hole along the first axis, and wherein the picking tool is movable through said through-hole.

10. The component mounting arrangement according to claim 9, wherein the first docking element is ring shaped and arranged on an inner surface of the through-hole, and wherein the second docking element is sleeve shaped and arranged along the first axis on the picking tool.

11. The component mounting arrangement according to claim 9 or 10, wherein the docking arrangement comprises at least two second docking elements arranged at different locations along the first axis on the picking tool, thus allowing the docking arrangement to hold the picking tool in at least two different resting positions.

12. The component mounting arrangement according to any one of the preceding claims, wherein the locking arrangement comprises a latch (130) configured to engage the picking tool in order to restrict movement of the picking tool towards the resting position.

13. The component mounting arrangement according to any one of the preceding claims, further comprising a processing unit configured to monitor a property of the electromagnetic coil in order to determine when the component held by the picking tool makes contact with a surface.

14. A component mounting machine comprising the component mounting arrangement according to any one of claims 1 to 13.

15. A method for operating a component mounting arrangement comprising:
a picking tool for picking and placing components, wherein the picking tool extends along a first axis;
a carriage for moving the picking tool back and forth along the first axis;
a locking arrangement comprising an electromagnetic coil, wherein the locking arrangement is configured to selectively assume:
a first state, wherein the picking tool and the carriage are coupled by means of a magnetic force generated by the electromagnetic coil, wherein the magnetic force is sufficient to move the picking tool from a resting position, and
a second state, wherein the picking tool and the carriage are uncoupled, thus allowing the picking tool to remain in the resting position when the carriage is moved;
wherein the method comprises:
passing (900) an electrical current through the electromagnetic coil, thus generating the magnetic force and causing the locking arrangement to switch from the second state to the first state; and
moving (902) the carriage along the first axis, thus moving the picking tool along the first axis.
